Europäisches Patentamt

European Patent Office

Office européen des brevets

(11) Veröffentlichungsnummer: **0 617 463 A1**

(12) **EUROPÄISCHE PATENTANMELDUNG**

(21) Anmeldenummer: **94103128.8**

(22) Anmeldetag: **02.03.94**

(51) Int. Cl.5: **H01L 21/60**, H01L 21/90

(30) Priorität: **24.03.93 DE 4309611**

(43) Veröffentlichungstag der Anmeldung:
**28.09.94 Patentblatt 94/39**

(84) Benannte Vertragsstaaten:
**AT DE FR GB IT NL**

(71) Anmelder: **SIEMENS AKTIENGESELLSCHAFT**
**Wittelsbacherplatz 2**
**D-80333 München (DE)**

(72) Erfinder: **Melzner, Hanno, Dipl.-Phys.**
**Kleinhelfendorf 4A**
**D-85655 Grosshelfendorf (DE)**

(54) **Herstellverfahren für ein Kontaktloch.**

(57) Das Herstellverfahren betrifft ein Kontaktloch, das eine untenliegende erste leitende Schicht (2) isoliert zu einer darüberliegenden und mit einer zweiten isolierenden Schicht (5) abgedeckten zweiten leitenden Schicht (4) freilegt. Erfindungsgemäß wird nach dem Ätzen der zweiten isolierenden Schicht (5) die zweite leitende Schicht (4) isotrop geätzt, so daß ein Spalt (7) unter der zweiten isolierenden Schicht (5) entsteht, der durch Herstellen von isolierenden Spacern (9) an den Kontaktloch-Seitenwänden aufgefüllt wird. Da nur schmale Spacer (9) benötigt werden, ist die Kontaktfläche (8') gegenüber bekannten Verfahren vergrößert. Mit dem Verfahren können besonders vorteilhaft Bitleitungs-Kontaktlöcher bei DRAM-Speicherzellen mit auf dem Kondensator angeordneter Bitleitung hergestellt werden.

FIG 2

EP 0 617 463 A1

Die Erfindung betrifft ein Herstellverfahren für ein Kontaktloch in einer Halbleiterstruktur, die eine erste leitende Schicht, eine darüber angeordnete erste isolierende Schicht, eine darüber angeordnete zweite leitende Schicht und eine darüber angeordnete zweite isolierende Schicht aufweist, und wobei das Kontaktloch die erste leitende Schicht isoliert zur zweiten leitenden Schicht freilegt.

Bei der Herstellung von integrierten Schaltungen werden auf einem Halbleitersubstrat, beispielsweise bei der Verdrahtung, eine Anzahl von leitenden Schichten aufgebracht, die durch isolierende Schichten voneinander getrennt sind.Es ist üblich, durch Kontaktlöcher in einer isolierenden Schicht jeweils zwei aufeinanderfolgende (d.h. nur durch die betreffende isolierende Schicht getrennte) leitende Schichten zu verbinden, indem vor Herstellung der oberen leitenden Schicht ein Kontaktloch in die isolierende Schicht geätzt wird.

Es gibt jedoch auch Situationen, in denen eine elektrische Verbindung zwischen einer unteren (ersten) leitenden Schicht und einer später folgenden - d.h. nicht der darauffolgenden zweiten, sondern z.B. dritten - leitenden Schicht erforderlich ist, wobei die dazwischen liegende zweite leitende Schicht in der fertigen Anordnung nicht kontaktiert werden darf. In einem solchen Fall wird üblicherweise die zweite leitende Schicht nach ihrer Herstellung so strukturiert, daß sie an der Stelle des späteren Kontaktloches entfernt wird, und nach Herstellung der der zweiten isolierenden Schicht wird das Kontaktloch durch die beiden aufeinander liegenden isolierenden Schichten geätzt. Dabei muß sichergestellt sein, daß ein notwendiger Isolationsabstand $i_{min}$ zwischen der zweiten leitenden Schicht (d.h. ihren Kanten) und den Seitenwänden des Kontaktlochs auch bei größtmöglicher Dejustierung der beiden diesen Abstand bestimmenden Fotomasken vorhanden ist. Offensichtlich wird dadurch der Platzbedarf einer solchen Verbindung stark erhöht.

Ein Beispiel für eine solche elektrische Verbindung ist der Bitleitungskontakt bei DRAM-Zellkonzepten, bei denen der Kondensator als stacked capacitor unter der Bitleitung angeordnet ist. Der Kontakt der Bitleitung (als dritte leitende Schicht) muß dann durch die Kondensatorebene (zweite leitende Schicht) zum S/D-Gebiet (1. leitende Schicht) des Auswahltransistors hergestellt werden und muß isoliert zum Kondensator erfolgen.

Für derartige Bitleitungskontakte sind Verfahren bekannt, die eine selbstjustierte Herstellung des Kontaktlochs zum Kondensator ermöglichen. Dabei wird auf die Strukturierung der Zellplatte (2. leitende Schicht) vor Abscheidung der folgenden zweiten isolierenden Schicht verzichtet, statt dessen wird, wie in dem Artikel von Itoh et al., VLSI Symposium 1991, Seite 9 beschrieben, ein Spacer an den Seitenwänden des Kontaktlochs erzeugt. Dadurch wird jedoch die tatsächliche Kontaktfläche stark verkleinert, da der Spacer mindestens die Dicke des Isolationsabstandes $i_{min}$ besitzen muß. Ferner ist eine Selbstjustage zum Gate und/oder Feldoxid nicht vorgesehen.

In dem Artikel von Küsters et al., Journal de Physique, C4, Tome 49, Sept. 1988, S. C4-503 ist offenbart, anstelle der Spacer-Bildung die freiliegende Kante der Zellplatte thermisch zu oxidieren, wodurch eine relativ große Kontaktfläche zur Verfügung steht. Ein Nachteil ist die Temperaturbelastung durch die Oxidation, die nach Fertigstellung der Transistoren so gering wie möglich sein sollte.

Der vorliegenden Erfindung liegt die Aufgabe zugrunde, ein Herstellverfahren für ein Kontaktloch anzugeben, das eine erste leitende Schicht isoliert zu einer darüberliegenden und mit einer zweiten isolierenden Schicht abgedeckten zweiten leitenden Schicht freilegt, wobei das Kontaktloch selbstjustiert zur zweiten leitenden Schicht ist. Es soll insbesondere anwendbar sein für die Herstellung eines Bitleitungskontaktlochs einer DRAM-Speicherzelle, bei der die Bitleitung oberhalb des Kondensators angeordnet ist.

Diese Aufgabe wird durch ein Herstellverfahren mit den Merkmalen des Patentanspruchs 1 gelöst.

Bei dem erfindungsgemäßen Verfahren wird ein wesentlich dünnerer Spacer benötigt als bei dem bekannten Verfahren, dadurch wird eine größere Kontaktfläche erhalten. Der notwendige Isolationsabstand zur zweiten leitenden Schicht wird dadurch sichergestellt, daß nach dem (mindestens teilweisen) Ätzen des Kontaktlochs die zweite leitende Schicht an den Seitenwänden des Kontaktlochs mit Hilfe einer isotropen Ätzung entfernt wird, so daß ein waagerechter Spalt mit einstellbarer horizontaler Ausdehnung entsteht. Bei der anschließenden Abscheidung des Spacermaterials wird dieser Spalt gefüllt, und der gesamte Isolationsabstand beträgt $x + d_{sp}$ ($d_{sp}$ = Spacerdicke). Die Spacerdicke kann also um x geringer sein als bei den bekannten Verfahren. Sie muß jedoch mindestens halb so groß wie die Schichtdicke y der zweiten leitenden Schicht sein, damit der Spalt gefüllt wird. Die Kontaktfläche wird allseitig nur um $d_{sp} = y/2$ verringert, bzw. das lithographisch definierte Kontaktloch muß allseitig nur um y/2 größer sein als die tatsächlich benötigte Kontaktfläche.

Bei Anwendung des Verfahrens bei der Herstellung eines Bitleitungskontaktlochs kann eine Selbstjustage auch zum Feldoxid und Gate erzielt werden. In einer solchen Anordnung ist die maximale Kontaktfläche durch den vorgegebenen Abstand zwischen zwei Gates (bzw. ihrer seitlichen Isolation) bestimmt, diese Fläche wird nur durch die schmalen Spacer, die sehr viel schmaler sein können als $i_{min}$, verringert.

Im folgenden wird die Erfindung anhand von Ausführungsbeispielen und den Figuren näher erläutert. Es zeigen

Figur 1, 2    eine Ausführungsform des Herstellverfahrens anhand eines Schnittes durch ein Halbleitersubstrat,

Figur 3, 4    eine Ausführungsform des Verfahrens zur Herstellung eines Bitleitungskontaktlochs,

Figur 5    einen vergrößerten Ausschnitt aus Figur 4.

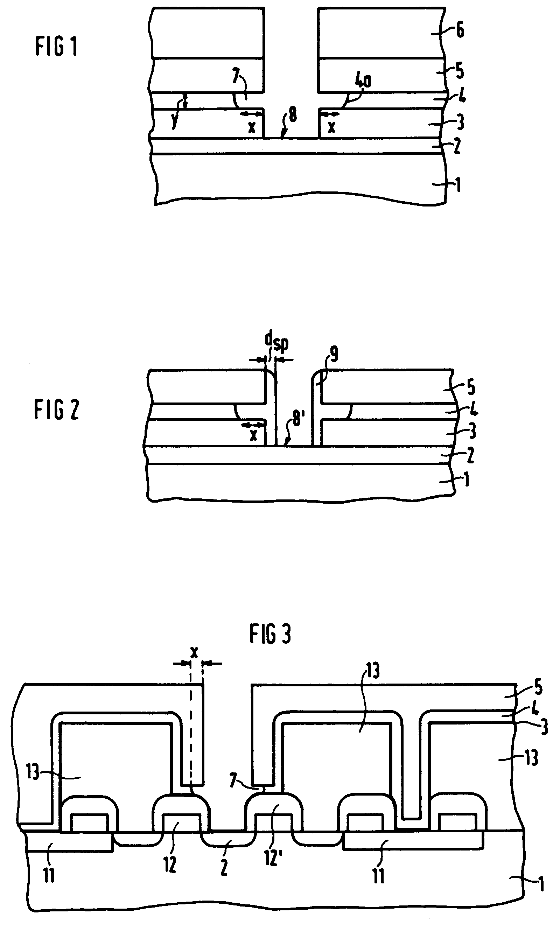

Figur 1: Gemäß einer ersten Ausführungsform des Verfahrens befindet sich auf bzw. in einem Halbleitersubstrat 1 eine leitende Schicht 2, die auch bereits strukturiert sein kann oder in Form eines dotierten Gebietes vorliegen kann. Darauf wird eine erste isolierende Schicht 3 z.B. aus Siliziumoxid aufgebracht und ggf. strukturiert. An der Stelle des zu bildenden Kontaktlochs bleibt sie jedoch vorhanden. Eine zweite leitende Schicht 4 wird aufgebracht und ggf. strukturiert, auch sie wird jedoch an der Stelle des späteren Kontaktlochs nicht entfernt. Dann wird die zweite isolierende Schicht 5, z.B. aus Siliziumoxid, aufgebracht. Die leitenden Schichten können aus Polysilizium bestehen.

Nun wird eine Fotolackmaske 6 erzeugt, mit der das lithographische Kontaktloch bzw. die lithographische Kontaktfläche 8 definiert wird. Mit dieser wird zunächst die zweite isolierende Schicht 5 anisotrop und vorzugsweise selektiv zur zweiten leitenden Schicht geätzt. Anschließend wird die zweite leitende Schicht im wesentlichen isotrop und selektiv zur unterliegenden ersten isolierenden Schicht geätzt, so daß ein waagerechter Spalt 7 unter der zweiten isolierenden Schicht entsteht. Seine horizontale Ausdehnung x kann durch die Ätzzeit euingestellt werden, seine vertikale Ausdehnung y ist durch die Schichtdicke der zweiten leitenden Schicht gegeben. Anschließend wird die erste isolierende Schicht 3 anisotrop geätzt, bis die erste leitende Schicht 2 freigelegt ist (lithographisch definierte Kontaktfläche 8). Die Lackmaske 6 wird nun entfernt; sie kann aber auch je nach Material und Dicke der isolierenden Schichten und Selektivität der eingesetzten Ätzprozesse vor dem anisotropen Ätzen der ersten isolierenden Schicht 3 oder bereits vor dem Ätzen der zweiten leitenden Schicht 4 entfernt werden.

Figur 2: Nach dem Freilegen der ersten leitenden Schicht 2 werden an den Kontaktloch-Seitenwänden isolierende Spacer 9 mit Hilfe bekannter Techniken hergestellt. Die Spacerdicke muß dabei so bemessen sein, daß einerseits der waagerechte Spalt 7 vollständig gefüllt wird - also mindestens halb so dick wie die zweite leitende Schicht mit Schichtdicke y - , und andererseits die Summe aus horizontaler Unterätzung x und Spacerdicke mindestens den notwendigen Isolationsabstand $i_{min}$ ergibt. Um eine möglichst große tatsächliche Kontaktfläche 8' zu erhalten, ist die Spacerdicke $d_{sp}$ vorzugsweise etwa gleich y/2, und die Unterätzung x wird entsprechend den Erfordernissen angepaßt, so daß $x + y/2 \geq i_{min}$.

Die erste isolierende Schicht kann auch während der Spacerätzung entfernt werden, insbesondere wenn sie eine geringe Schichtdicke aufweist. Die Spacerherstellung wird dann im Anschluß an die isotrope Ätzung der zweiten leitenden Schicht 4 durchgeführt.

Ist die Schichtdicke y nicht deutlich kleiner als die geplante Unterätzung x, wird eine Kombination aus anisotroper und isotroper Ätzung bei der Ätzung der zweiten leitenden Schicht eingesetzt, um eine im wesentlichen vertikale Kante 4a der Schicht zu erzielen.

Figur 3: Das erfinderische Verfahren ist besonders vorteilhaft einsetzbar bei der Herstellung eines Kontaktlochs, das eine Bitleitung einer DRAM-Speicherzelle des oben genannten Typs mit einem S/D-Gebiet des zugehörigen Auswahltransistors verbindet. Soll dieses Kontaktloch selbstjustiert zum Gate des Transistors hergestellt werden, ist die maximal mögliche Kontaktfläche durch den Abstand zweier benachbarter, mit einer Isolationeinkapselung versehenen Gates sowie durch Feldoxidbereiche vorgegeben.

In Figur 3 ist ein Halbleitersubstrat 1 mit Feldoxidbereichen 11 und einem S/D-Gebiet als erste leitende Schicht 2 dargestellt, sowie auf dem Halbleitersubstrat angeordnete Gates 12 mit einer Gateeinkapselung 12', eine untere Kondensatorplatte 13, ein Kondensatordielektrikum als erste isolierende Schicht 3, eine Zellplatte als zweite leitende Schicht 4 und ein planarisiertes Dielektrikum als zweite isolierende Schicht 5. Mit Hilfe einer (nicht dargestellten) Lackmaske wird zunächst das lithographisch definierte Kontaktloch zumindest teilweise hergestellt, indem wie oben erläutert das planarisierte Dielektrikum 5 anisotrop und vorzugsweise selektiv zur Zellplatte 4 geätzt wird und dann die Zellplatte im wesentlichen isotrop und vorzugsweise selektiv zum unterliegenden Kondensatordielektrikum 3 geätzt wird. Es entsteht ein waagerechter Spalt 7 mit horizontaler Ausdehnung x.

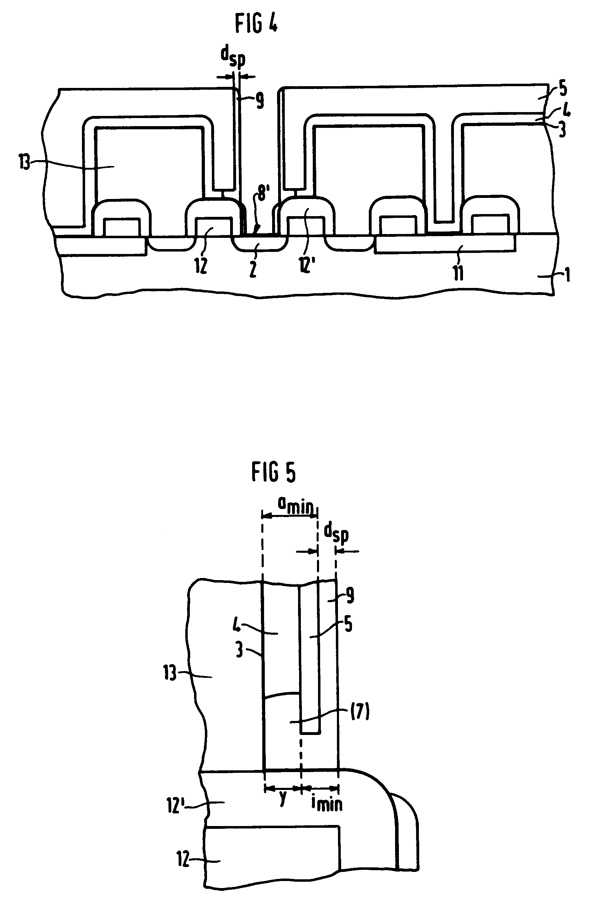

Figur 4: Vorzugsweise direkt nach der isotropen Ätzung wird an den Seitenwänden ein Spacer 9 hergestellt, dessen Dicke $d_{sp}$ etwa gleich der halben Schichtdicke der zweiten leitenden Schicht 4 ist. In jedem Fall muß der waagerechte Spalt 7 gefüllt werden. Bei der Spacerätzung wird gleichzeitig das dünne Kondensatordielektrikum 3 auf dem Boden des Kontaktlochs entfernt und die Kontaktfläche 8' freigelegt, die allseitig um $d_{sp} = y/2$ kleiner ist als die ursprüngliche lithographisch definierte Kontaktfläche oder die maximal mögliche, durch die Gates und das Feldoxid definierte Kontaktfläche.

Wie bereits erläutert, reicht ein wesentlich dünnerer Spacer als bei bekannten Verfahren aus, so daß die Verkleinerung der Kontaktfläche wesentlich geringer ist, bzw. die Gates bei vorgegebener benötigter Kontaktfläche enger zusammengerückt werden können.

Figur 5: In dem vergrößerten Ausschnitt ist dargestellt, daß der geätzte Spalt nur solange waagerecht verläuft, bis die benachbarte untere Kondensatorplatte 13 erreicht ist. Bei weiterer isotroper Ätzung knickt der Spalt nach oben ab, und der Isolationsstand wird nicht weiter erhöht. Die lithographisch definierte Kante des Kontaktlochs muß daher mindestens

$$a_{min} = i_{min} - d_{sp} + y$$
$$= i_{min} + y/2$$

von der unteren Kondensatorplatte 13 entfernt sein. Das heißt, die Zellplatte 4 sollte möglichst dünn sein, um einerseits $a_{min}$ zu verkleinern und andererseits die Verkleinerung der Kontaktfläche durch die Spacer gering zu halten. Da der Abstand $a_{min}$ auch im Fall einer Dejustage des lithographisch definierten Kontaktlochs gegen den Kondensator eingehalten werden muß, beträgt der vorzusehende Abstand

$$a_{min} + \Delta = i_{min} + y/2 + \Delta$$

wobei $\Delta$ den Kantenlagefehler bezeichnet. Verglichen mit einer konventionellen Herstellung des Bitleitungskontaktes (d.h. Entfernen der zweiten leitenden Schicht an der Stelle des späteren Kontaktlochs vor dem Abscheiden der zweiten isolierenden Schicht) wird der Abstand zwischen Kondensator und Bitleitungskontakt um $\Delta + y/2$ verringert.

**Patentansprüche**

1. Herstellverfahren für ein Kontaktloch in einer Halbleiterstruktur, die
   eine erste leitende Schicht (2),
   eine darüber angeordnete erste isolierende Schicht (3), eine darüber angeordnete zweite leitende Schicht (4) und eine darüber angeordnete zweite isolierende Schicht (5) aufweist,
   und wobei das Kontaktloch die erste leitende Schicht (2) isoliert zur zweiten leitenden Schicht (4) freilegt, mit folgenden Schritten:
   - anisotropes Ätzen der zweiten isolierenden Schicht (5) unter Verwendung einer das Kontaktloch lithographisch definierenden Fotolackmaske (6)
   - überwiegend isotropes Ätzen der zweiten leitenden Schicht (4), so daß ein waagerechter Spalt (7) unter der zweiten isolierenden Schicht (5) entsteht
   - Herstellen von isolierenden Spacern (9) an den Seitenwänden des Kontaktlochs
   - Ätzen der ersten isolierenden Schicht (3) vor, während oder nach der Spacerherstellung.

2. Herstellverfahren nach Anspruch 1, **dadurch gekennzeichnet**, daß für das Ätzen der zweiten isolierenden Schicht (5) und/oder der zweiten leitenden Schicht (4) Ätzprozesse eingesetzt werden, die eine hohe Selektivität zur jeweils unterliegenden Schicht aufweisen.

3. Herstellverfahren nach einem der Ansprüche 1 bis 2, **dadurch gekennzeichnet**, daß als erste leitende Schicht (2) ein dotiertes Gebiet in einem Halbleitersubstrat (1) und/oder als erste isolierende Schicht (3) eine ONO-3fach-Schicht und/oder als zweite leitende Schicht (4) eine Polysiliziumschicht und/oder als zweite isolierende Schicht (5) eine planarisierte Siliziumoxidschicht verwendet wird.

4. Herstellverfahren nach einem der Ansprüche 1 bis 3, **dadurch gekennzeichnet**, daß der Spacer (9) in einer Dicke hergestellt wird, die etwa der halben Schichtdicke der zweiten leitenden Schicht entspricht.

5. Herstellverfahren nach einem der Ansprüche 1 bis 4, **dadurch gekennzeichnet**, daß bei vorgewähltem Isolationsabstand $i_{min}$ zwischen der zweiten leitenden Schicht und dem Kontaktloch die horizontale Ausdehnung x des Spaltes (7) und die Spacerdicke $d_{sp}$ so gewählt werden, daß $x + d_{sp} \geq i_{min}$ ist.

6. Kontaktlochanordnung bei einer Halbleiterstruktur mit einer ersten leitenden Schicht (2),
   einer darüber angeordneten ersten isolierenden Schicht (3), einer darüber angeordneten zweiten leitenden Schicht (4) und einer darüber angeordneten zweiten isolierenden Schicht (5), wobei das Kontaktloch die erste leitende Schicht (2) isoliert zur zweiten leitenden Schicht freilegt,
   **dadurch gekennzeichnet**, daß
   - das Kontaktloch selbstjustiert zu den Kanten (4a) der zweiten leitenden Schicht angeordnet ist,
   - die Seitenwände des Kontaktlochs mit einem isolierenden Spacer (9) bedeckt sind, dessen horizontale Ausdehnung an der Kante (4a) der zweiten isolierenden Schicht (4) mindestens einem vorgewählten Isolationsabstand $i_{min}$ entspricht und an den übrigen Bereichen der Seitenwände geringer ist.

7. Kontaktlochanordnung nach Anspruch 6, **dadurch gekennzeichnet**, daß die horizontale Ausdehnung des Spacers (9) an den übrigen Bereichen der Seitenwände (Spacerdicke) etwa der halben Schichtdicke der zweiten leitenden Schicht (4) entspricht.

8. Verwendung einer Kontaktlochanordnung nach einem der Patentansprüche 6 bis 7 als Bitleitungskontaktloch in einer Halbleiterspeicheranordnung, bei der ein Speicherkondensator im wesentlichen oberhalb eines Transistors und im wesentlichen unterhalb der Bitleitung angeordnet ist.

FIG 1

FIG 2

FIG 3

FIG 4

FIG 5

Europäisches
Patentamt

**EUROPÄISCHER RECHERCHENBERICHT**

Nummer der Anmeldung

EP 94 10 3128

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| X | PATENT ABSTRACTS OF JAPAN<br>vol. 13, no. 132 (E-736)31. März 1989<br>& JP-A-63 299 142 (NEC CORP.) 6. Dezember 1988<br>* Zusammenfassung * | 1,2,6 | H01L21/60<br>H01L21/90 |
| A | | 2-5 | |
| | --- | | |
| X | DE-A-42 03 565 (MITSUBISHI DENKI K.K.)<br>* Spalte 3, Zeile 54 - Spalte 4, Zeile 65 *<br>* Spalte 5, Zeile 24 - Spalte 6, Zeile 7 *<br>* Spalte 7, Zeile 33 - Spalte 8, Zeile 21 * | 6,7 | |
| A | | 3 | |
| | --- | | |
| P,X | US-A-5 262 352 (M.P.WOO ET AL.)<br>----- | 1-3,6 | |
| | | | RECHERCHIERTE SACHGEBIETE (Int.Cl.5) |
| | | | H01L |

Der vorliegende Recherchenbericht wurde für alle Patentansprüche erstellt

| Recherchenort | Abschlußdatum der Recherche | Prüfer |
|---|---|---|
| DEN HAAG | 30. Juni 1994 | Schuermans, N |